# EUROPÄISCHE PATENTSCHRIFT

(11) **EP 3 455 909 B1**
(45) Veröffentlichungstag und Bekanntmachung des Hinweises auf die Patenterteilung: **25.11.2020**
(21) Anmeldenummer: 17718471.0
(22) Anmeldetag: 22.03.2017
(51) Int. Cl.: H01R 13/627, H01R 13/629, H01R 13/641, H01R 12/72, H01R 12/70

(54) **STECKKONTAKTSET UND VERFAHREN ZUM PRÜFEN EINER VERRASTUNG DES STECKKONTAKTSETS**
PLUG CONTACT AND METHOD FOR TESTING LATCHING MECHANISM OF PLUG CONTACT
UNE FICHE DE CONTACT ET UNE MÉTHODE POUR TESTER LE MÉCANISME DE VERROUILLAGE DE LA FICHE DE CONTACT

(30) Priorität: 13.05.2016 DE 102016108989
(43) Veröffentlichungstag der Anmeldung: 20.03.2019
(73) Patentinhaber: ERNI Production GmbH & Co. KG, 73099 Adelberg (DE)
(72) Erfinder: LAPPÖHN, Jürgen, 73108 Gammelshausen (DE)
(74) Vertreter: Jakelski & Althoff Patentanwälte PartG mbB
(86) Internationale Anmeldenummer: PCT/DE2017/100229
(87) Internationale Veröffentlichungsnummer: WO 2017/194044

(56) Entgegenhaltungen:
- DE-A1- 3 838 657
- DE-U1-202016 102 037
- US-A- 5 088 931
- US-A1- 2004 192 092
- US-A1- 2005 196 995
- US-A1- 2007 001 279
- US-A1- 2010 167 570
- US-A1- 2013 330 940
- US-A1- 2014 162 492
- US-A1- 2015 214 673
- US-A1- 2015 255 905

## Beschreibung

Die vorliegende Erfindung betrifft ein Steckkontaktset, umfassend eine Stecckontaktleiste mit mehreren als Bestandteil einer Leiterplatte ausgebildeten, im Bereich eines Leiterplattenrandes angeordneten ersten Kontaktelementen, und mit einem Steckverbinder mit zweiten Kontaktelementen, der als Leiterplattendirektsteckverbinder ausgebildet ist. Die Erfindung betrifft auch ein Verfahren zum Prüfen einer Verrastung mindestens eines Rastelements der Steckkontaktleiste und mindestens einem Rastelement des Steckverbinders.

Derartige Leiterplattendirektsteckverbinder werden direkt auf eine entsprechende Steckkontaktleiste, die an einem Leiterplattenrand ausgebildet ist, aufgeschoben. Auf diese Weise kann eine Steckkontaktleiste, die beispielsweise auch auf der Leiterplatte angeordnet ist und mit entsprechenden Kontaktelementen auf der Leiterplatte elektrisch kontaktiert ist, entfallen. Vielmehr bilden entsprechende Kontaktelemente auf der Leiterplatte selbst den Widerpart zu dem Leiterplattendirektsteckverbinder.

Derartige Leiterplattendirektsteckverbinder kommen auch in Baugruppen, die in modernen Kraftfahrzeugen in großem Umfang verbaut sind, zum Einsatz.

Während des Betriebs des Fahrzeugs unterliegen derartige Steckverbindungen erheblichen Belastungen, beispielsweise Rüttelbelastung, Vibrationsbelastung und dergleichen. Durch diese Belastungen kann es zu einem Herauslösen des Steckverbinders aus der Steckkontaktleiste und damit zu einem Verlust der elektrischen Kontaktierung kommen. Um dies zu verhindern, müssen die Steckverbinder und der entsprechende Gegenpart, beispielsweise eine Steckkontaktleiste mit Rastelementen versehen sein, die ein unbeabsichtigtes Herauslösen des Steckverbinders aus der Steckkontaktleiste beziehungsweise vom Leiterplattenrand verhindern. Bei der Montage der Steckverbinder werden diese Rastelemente miteinander verrastet, um eine durch im Kraftfahrzeug auftretende Belastung nicht lösbare Verbindung zwischen dem Steckverbinder und dem entsprechenden Widerpart, also beispielsweise einer Steckkontaktleiste oder der Leiterplatte herzustellen.

Durch Montagefehler kann es zu einer sogenannten Halbsteckung eines Steckverbinders in eine Steckkontaktleiste kommen. Hierbei wird zwar ein elektrischer Kontakt zwischen den Steckkontakten der Steckkontaktleiste und Steckkontakten des Steckverbinders hergestellt, es erfolgt jedoch keine Verrastung der Rastelemente. Aufgrund einer räumlich dichten Anordnung von Steckkontaktsets in Kraftfahrzeugen ist eine solche Halbsteckung in der Regel optisch nicht erkennbar. Auch durch eine Messung des Stromflusses zwischen Steckkontaktleiste und Steckverbinder kann eine Halbsteckung nicht detektiert werden, da ein elektrischer Kontakt zwischen Steckverbinder und Steckkontaktleiste besteht, der von der gewünschten Vollsteckung nicht unterscheidbar ist. Erst während des Betriebs des Kraftfahrzeugs kann ein Verlust der elektrischen Kontaktierung zwischen Steckverbinder und Steckkontaktleiste auftreten, welcher dann zwar von der On-Board-Diagnose (OBD) des Kraftfahrzeugs erkannt wird, jedoch erst in einer Werkstatt behoben werden kann. Um eine solche Halbsteckung feststellen zu können, wurde nun vorgeschlagen, mindestens einen Steckkontakt als sogenannten Prüfkontakt mit geringerer Länge als die restlichen Steckkontakte auszubilden. Dieser Prüfkontakt tritt nur in elektrischen Kontakt zu einem korrespondierenden Steckkontakt in dem Steckverbinder, wenn eine vollständige Steckung, also eine Vollsteckung zwischen Steckverbinder und Steckkontaktleiste vorgenommen wurde. Um diese Vollsteckung auch über längere Zeiträume zu gewährleisten, sind erste und zweite Rastelemente vorgesehen, die miteinander verrastet sind, wenn eine solche Vollsteckung vorgenommen wurde. Ein derartiges Steckkontaktset geht beispielsweise aus der EP 0 314 949 A1 hervor. Die ordnungsgemäße Steckung wird dabei dadurch festgestellt, dass geprüft wird, ob ein Bestromen des Prüfkontakts oder des korrespondierenden Steckkontakts in der Steckkontaktleiste in den entsprechenden korrespondierenden Kontakt des Gegenparts, also des Steckverbinders beziehungsweise der Steckkontaktleiste detektiert werden kann. Erst wenn ein Stromfluss detektiert werden kann, kann von einer ordnungsgemäßen Steckung ausgegangen werden.

Diese Steckkontaktsets weisen ein Längsspiel von etwa 0,9 mm bis 1,00 mm auf. Zu Beginn der Steckung, also bei Ausnutzung des maximalen Längsspiels, sind der Steckverbinder und die Steckkontaktleiste durch die ersten und zweiten Rastelemente miteinander verrastet und es sind zwar alle Stecckontakte elektrisch leitend kontaktiert, nicht jedoch der Prüfkontakt. Das Längsspiel ist erforderlich, um Toleranzen des Messerkontaktelements und des Federkontaktelements, die den Prüfkontakt bilden, auszugleichen. Während der Montage werden die Steckverbinder auf die Steckkontaktleisten geschoben. Dabei ist es erforderlich, dass die Steckverbinder bis auf den Grund der Steckkontaktleiste geschoben werden. In diesem Falle sind alle Stecckontakte und auch der Prüfkontakt elektrisch korrekt kontaktiert. Unter elektrisch "korrekt kontaktiert" wird vorliegend nicht nur eine zufällige Berührung der beiden Kontaktelemente, zum Bespiel der Spitze eines Messerkontaktelements und des Federkontaktelements, verstanden, sondern eine vollständige Kontaktierung, beispielsweise durch vollständiges Ineinanderschieben der Messerkontaktelemente in die Federkontaktelemente. Nun kann während der Montage der Fall eintreten, dass sich ein Steckverbinder innerhalb des Längsspiels wieder etwas aus der Steckkontaktleiste herauslöst, weil beispielsweise an den Kabeln gezogen wurde, die zu den Steckverbindern führen, oder dergleichen. Dieser Fall kann insbesondere auch noch nach einer ordnungsgemäßen Steckung des Steckverbinders auftreten. Wenn dabei der Steckverbinder soweit aus der Steckkontaktleiste herausgelöst wurde, dass das Längsspiel voll ausgenutzt wurde, tritt der Fall ein, dass der Prüfkontakt des Steckverbinders nicht mehr mit der den entsprechenden Stecckontakten der Steckkontaktleiste elektrisch leitend verbunden ist. In diesem Falle wird ein oben beschriebener Defekt signalisiert, der als sogenannter Pseudofehler während der Fertigung bezeichnet wird. "Pseudofehler" deshalb, weil eigentlich gar kein Fehler vorliegt, denn die Steckkontakte, also die Nutzkontakte sind in diesem Falle alle korrekt kontaktiert, mit Ausnahme des Prüfkontaktes. Während der Montage wird dies allerdings als Fehler festgestellt. Ein solcher Fehler ist deshalb besonders störend und nachteilig, weil auch bei einer Inaugenscheinnahme der Steckkontaktsets eine ordnungsgemäße Steckung erkennbar ist, da ja die Rastelemente miteinander verrastet sind. Eine solche Fehlkontaktierung ist bei der Montage besonders störend, da während des Montageprozesses Fehlkontaktierungen signalisiert werden, die den Montageprozess verzögern.

Die US 2015/255905 A1 offenbart einen USB-Steckverbinder, der an der Seite einer Leiterplatte angeordnet ist. Die US 2007/0001279 A1 offenbart eine Halbleitervorrichtung für eine Speicherkarte oder eine Kartenvorrichtung, die als Multifunktionskarte dargestellt ist. Die US 2013/330940 A1 offenbart ein erstes und ein drittes Rastelement, die beide Teil einer Leiterplatte sind und ein zweites Rastelement, welches Teil eines Gehäuses ist. Die DE 20 2016 102037 U1 offenbart ein Steckkontaktset mit einer Steckkontaktleiste in Form eines Steckverbinders und einem Steckverbinder.

Aus der US 2004/0192092 A1 geht ein System und ein Verfahren zum Verhindern elektrischer Lichtbögen in mit hohen Stromstärken beaufschlagten Steckverbindern hervor, welche mehrere Rastelemente aufweisen, um die beiden Steckverbinderteile in unterschiedlichen Positionen miteinander zu verrasten. Die beiden Steckverbinderteile umfassen Träger aus einem elektroisolierenden Material, in dem zwei Paare von Leistungsklemmen angeordnet sind, die mit jeweiligen Leitungen verbunden sind, sowie ein Paar von zusätzlichen Klemmen, die mit einer Detektionsleitung und einem Masseanschluss verbunden sind. In einer ersten Rastposition sind lediglich die Leistungsklemmen elektrisch kontaktiert, nicht jedoch die Detektionsklemmen, während in einer vollständig verrasteten Anordnung in einer zweiten Position die Leistungsklemmen und die Detektionsklemmen verrastet sind. Hierzu sind mehrere Rastelemente vorgesehen, wobei die Rastelelemente in Steckrichtung so angeordnet sind, dass eine Verrastung in der ersten und der zweiten Position erzielt wird.

Steckverbinder mit unterschiedlich langen Steckkontaktelementen gehen auch aus der US 5,088,931 sowie aus der DE 38 38 657 A1 hervor.

Die US 2010/0167570 A1 offenbart einen elektrischen Steckverbinder, bei dem Kontaktelemente auf einer Leiterplatte angeordnet sind.

Insbesondere bei einem derartigen Leiterplattensteckverbinder kann eine verkantete, schräge Steckung auftreten, die zu einer fehlerhaften Kontaktierung führen kann.

### Offenbarung der Erfindung

Die erfindungsgemäße Lösung mit genau einem Prüfkontakt, der mittig in der Steckkontaktleiste angeordnet ist, ermöglicht die Überprüfung einer ordnungsgemäßen Steckung besonders bei einem Steckverbinder, der an einer Leiterplatte angeordnet ist.

Durch diese Anordnung wird festgestellt, ob eine gleichmäßige, also insbesondere nicht verkantete oder schräge, sondern parallele Steckung des Steckverbinders in die Kontaktleiste der Leiterplatte vorgenommen wurde. Nur in diesem Falle tritt keine Stromunterbrechung auf.

Es ist bei diesem Steckkontaktset für Leiterplatten ein drittes Rastelement vorgesehen, dass entweder bei einer ersten Variante mit einem zweiten Rastelement verrastet und bei einer zweiten Variante mit einem ersten Rastelement verrastet. Dieses dritte Rastelement ist in Steckrichtung bei der ersten Variante von dem ersten Rastelement und bei der zweiten Variante von dem zweiten Rastelement so beabstandet angeordnet, dass durch eine Verrastung des dritten Rastelements mit dem ersten beziehungsweise zweiten Rastelement eine weitestgehend spielfreie Fixierung des Steckergehäuses an der Leiterplatte im vollständig kontaktierten Zustand der ersten und zweiten Steckkontakte erzielt wird.

Bei der ersten Variante ist dabei vorgesehen, dass das erste und dritte Rastelement an der Leiterplatte selbst ausgebildet sind, während das zweite Rastelement an dem Gehäuse des Leiterplattendirektsteckverbinders angeordnet ist und bei der zweiten Variante ist es umgekehrt, es sind nur das erste Rastelement an der Leiterplatte und das zweite und dritte Rastelement an dem Gehäuse des Leiterplattendirektsteckverbinders angeordnet. Beide Lösungen sind jedoch gleichwertig und unterscheiden sich im Wesentlichen nur in der Herstellung der Rastelemente an der Leiterplatte beziehungsweise an dem Gehäuse oder an den Elementen des Gehäuses des Direktsteckverbinders.

Durch dieses dritte Rastelement, welches ebenfalls mit dem ersten beziehungsweise zweiten Rastelement verrastbar ist und welches durch die Verrastung eine möglichst spielfreie Fixierung des Gehäuses an der Leiterplatte im vollständig kontaktierten Zustand der ersten und zweiten Steckkontakte ermöglicht, wird während des Montagevorgangs eine sichere Kontaktierung des Prüfkontakts mit dem korrespondierenden Steckkontakt sichergestellt und so Fehlermeldungen aufgrund des vorerwähnten Spiels, welche zu einer Nicht-Kontaktierung des Prüfkontakts führen können, vermieden. Darüber hinaus wird wirkungsvoll ein Herauslösen des Gehäuses aus dem entsprechenden Steckverbinder der Leiterplatte, also ein Herauslösen des Leiterplattendirektsteckverbinders aus der Steckkontaktleiste der Leiterplatte während des Betriebs beispielsweise eines Fahrzeugs verhindert. Durch dieses dritte Rastelement wird außerdem sichergestellt, dass der Steckverbinder vollständig in die Steckkontaktleiste gesteckt ist und in diesem Zustand verharrt. Ein "Nachstecken" des Steckverbinders ist auf diese Weise nicht mehr erforderlich. Ein solches Nachstecken ist beispielsweise bei den aus dem Stand der Technik bekannten Steckverbindern immer dann erforderlich, wenn eine Stromunterbrechung an dem Prüfkontakt festgestellt wurde. Der erste und einfache Weg der Prüfung, ob ein Defekt vorliegt, ist es dann, den Steckverbinder noch einmal etwas fester auf die Leiterplatte zu drücken, was durch einen Monteur während der Montage geschehen muss. Insbesondere bei sehr vielen zu montierenden Steckverbindern kann ein solcher zusätzlicher Montagevorgang sehr nachteilig sein. Durch die oben beschriebene Lösung wird ermöglicht, dass beim Einrasten des dritten Rastelements in das erste beziehungsweise zweite Rastelement sichergestellt ist, dass eine vollständige Steckung der Steckkontakte vorliegt und dass der Leiterplattendirektsteckverbinder und die Leiterplatte miteinander so verbunden sind, dass auch Rüttelbelastungen und andere mechanische Belastungen nicht zu einer Dekontaktierung der Steckkontakte führen können.

Die ersten Kontaktelemente sind vorteilhafterweise auf der Leiterplatte angeordnet. Die auf der Leiterplatte angeordneten Kontaktelemente sind bevorzugt metallische Flächen, die direkt - wie Leiterbahnen - auf der Oberfläche der Leiterbahnen, insbesondere nebeneinanderliegend angeordnet sind und so die Steckkontaktleiste bilden.

Ferner ist bevorzugt vorgesehen, dass die ersten und dritten Rastelemente in oder an der Leiterplatte als deren Teil ausgebildet sind.

Gemäß einer Ausführungsform sind die ersten und dritten Rastelemente jeweils an Rändern, welche eine Steckerzunge, die als Teil der Leiterplatte ausgebildet ist, quer zur Steckrichtung begrenzen angeordnet.

Die Steckerzunge kann beispielsweise in einer randseitigen Ausnehmung der Leiterplatte angeordnet sein. Rein prinzipiell ist es aber auch denkbar, dass sie über die Leiterplatte übersteht.

Gemäß einer alternativen Ausführungsform ist vorgesehen, dass die ersten und dritten Rastelemente Öffnungen in der Leiterplatte sind. In diesem Falle kann die Steckerzunge vollständig entfallen und die ersten und dritten Rastelemente sind beispielsweise als Bohrungen in der Leiterplatte, insbesondere benachbart zu deren Rand ausgebildet.

In diesen Fällen können die zweiten Rastelemente bevorzugt an an dem Gehäuse angeordneten Federarmen angeordnet sein. Diese Federarme übergreifen die an der Leiterplatte ausgebildeten Rastelemente bzw. greifen in diese während des Steckvorgangs ein und sichern das Gehäuse des Leiterplattendirektsteckverbinders an der Leiterplatte nach einer Steckung.

Bei der zweiten erfindungsgemäßen Variante ist vorgesehen, dass die ersten Rastelemente als Teil der Leiterplatte ausgebildet sind. Bei dieser zweiten erfindungsgemäßen Lösung ist vorgesehen, dass die zweiten und dritten Rastelemente an an dem Gehäuse angeordneten Federarmen angeordnet sind.

In allen Fällen können die Rastelemente bevorzugt als Rasthaken ausgebildet sein. Diese Rasthaken wirken besonders vorteilhaft mit den nach innen, auf die Rastelemente zu federnd angelenkten Federarmen zusammen.

Der Prüfkontakt weist - wie bereits vorstehend erwähnt - eine geringere Länge als die anderen Steckkontakte in der Steckkontaktleiste auf. Die restlichen Steckkontakte weisen dagegen im Wesentlichen dieselbe Länge auf.

Dabei ist der Prüfkontakt so kurz ausgebildet, dass er nicht in elektrischen Kontakt mit einem zweiten Steckkontakt tritt, wenn das wenigstens eine erste Rastelement nicht mit dem wenigstens einen zweiten Rastelement verrastet ist. Hierdurch wird festgestellt, ob der Stecker ordnungsgemäß gesteckt wurde. Das Steckkontaktset weist vorteilhafterweise drei Rastpunkte auf, einen ersten Rastpunkt, einen zweiten Rastpunkt und einen dritten Rastpunkt. Das wenigstens eine erste Rastelement ist in allen drei Rastpunkten mit dem wenigstens einen zweiten Rastelement verrastet und dabei ist der erste Rastpunkt so gewählt, dass kein zweiter Steckkontakt mit einem Prüfkontakt elektrisch in Kontakt tritt. In dem zweiten Rastpunkt tritt wenigstens ein zweiter Steckkontakt mit dem Prüfkontakt in elektrischen Kontakt und in dem dritten Rastpunkt sind alle ersten und zweiten Steckkontakte miteinander in Kontakt getreten und die beiden Gehäuseteile sind aneinander fixiert. Der zweite Rastpunkt ist also der Rastpunkt, der gewöhnlich eine ordnungsgemäße Steckung repräsentiert. Der dritte Rastpunkt entspricht dem zweiten Rastpunkt, jedoch ist hier absolut sichergestellt, dass alle Steckkontakte miteinander kontaktiert sind und dass die beiden Gehäuseteile nahezu spielfrei fixiert sind.

Bevorzugt sind die ersten Kontaktelemente Kontaktflächen auf der Leiterplatte und die zweiten Kontaktelemente sind vorteilhafterweise als Federkontaktelemente ausgebildet, die im kontaktierten Zustand unter einer Vorspannung auf den Kontaktelementen aufliegen.

Diese Ausführungen des erfindungsgemäßen Steckkontaktsets ermöglichen zwei Verfahren zum Prüfen einer Verrastung des mindestens einen Rastelements mit dem mindestens einen zweiten Rastelement und mit dem mindestens einen dritten Rastelement. Hierdurch kann unterschieden werden, ob die Steckkontaktleiste in gewünschter Weise mit dem Steckverbinder verrastet ist oder ob nur eine Halbsteckung ohne Verrastung vorliegt, die sich zudem aufgrund von Rüttelbelastungen oder anderen mechanischen Belastungen lösen kann.

In einer Ausführungsform des erfindungsgemäßen Verfahrens wird eine Verrastung des mindestens einen ersten Rastelements mit dem mindestens einen zweiten und dritten Rastelement dadurch geprüft, dass der Prüfkontakt bestromt wird und geprüft wird, ob ein Strom zwischen dem Prüfkontakt und einem zweiten Steckkontakt fließt. Wenn ein solcher Stromfluss detektiert wird, wird erkannt, dass eine Verrastung vorliegt. Dabei kann entweder der Prüfkontakt bestromt werden oder der zweite Steckkontakt, der eingerichtet ist, um elektrisch mit dem Prüfkontakt in Kontakt zu treten.

### Kurze Beschreibung der Zeichnungen

Ein Ausführungsbeispiel der Erfindung ist in den Zeichnungen dargestellt und in der nachfolgenden Beschreibung näher erläutert.
Fig. 1a zeigt eine isometrische Darstellung einer ersten Variante eines erfindungsgemäßen Steckkontaktsets aus Leiterplattendirektsteckverbinder und Leiterplatte im noch nicht gesteckten Zustand;
Fig. 1b zeigt das in Fig. 1a dargestellte Steckkontaktset im noch nicht vollständig gesteckten Zustand und
Fig. 1c zeigt das Steckverbinderset gemäß Fig. 1b in teilweise weggebrochenem Zustand zur Verdeutlichung der Nichtsteckung des Prüfkontakts;
Fig. 1d zeigt das Steckverbinderset gemäß Fig. 1b und 1c im vollständig gesteckten Zustand in seiner Endposition;
Fig. 1e zeigt das Steckverbinderset gemäß Fig. 1d in teilweise weggebrochenem Zustand zur Verdeutlichung der vollständigen Steckung aller Steckkontakte;
Fig 2a zeigt eine isometrische Darstellung einer zweiten Variante eines erfindungsgemäßen Steckkontaktsets aus Leiterplattendirektsteckverbinder und Leiterplatte im noch nicht gesteckten Zustand;
Fig. 2b zeigt das in Fig. 2a dargestellte Steckkontaktset im noch nicht vollständig gesteckten Zustand und
Fig. 2c zeigt das Steckverbinderset gemäß Fig. 2b in teilweise weggebrochenem Zustand zur Verdeutlichung der Nichtsteckung des Prüfkontakts;
Fig. 2d zeigt das Steckverbinderset gemäß Fig. 2b und 2c im vollständig gesteckten Zustand in seiner Endposition;
Fig. 2e zeigt das Steckverbinderset gemäß Fig. 2d in teilweise weggebrochenem Zustand zur Verdeutlichung der vollständigen Steckung aller Steckkontakte;
Fig 3a zeigt eine isometrische Darstellung einer dritten Variante eines erfindungsgemäßen Steckkontaktsets aus auch separat gezeigem Leiterplattendirektsteckverbinder und Leiterplatte im noch nicht gesteckten Zustand;
Fig. 3b zeigt das in Fig. 3a dargestellte Steckkontaktset im noch nicht vollständig gesteckten Zustand und
Fig. 3c zeigt das Steckverbinderset gemäß Fig. 3b in teilweise weggebrochenem Zustand zur Verdeutlichung der Nichtsteckung des Prüfkontakts;
Fig. 3d zeigt das Steckverbinderset gemäß Fig. 3b und 3c im vollständig gesteckten Zustand in seiner Endposition;
Fig. 3e zeigt das Steckverbinderset gemäß Fig. 3d in teilweise weggebrochenem Zustand zur Verdeutlichung der vollständigen Steckung aller Steckkontakte;
Fig 4a zeigt eine isometrische Darstellung einer vierten Variante eines erfindungsgemäßen Steckkontaktsets aus auch separat gezeigtem Leiterplattendirektsteckverbinder und Leiterplatte im noch nicht gesteckten Zustand;
Fig. 4b zeigt das in Fig. 4a dargestellte Steckkontaktset im noch nicht vollständig gesteckten Zustand und
Fig. 4c zeigt das Steckverbinderset gemäß Fig. 4b in teilweise weggebrochenem Zustand zur Verdeutlichung der Nichtsteckung des Prüfkontakts;
Fig. 4d zeigt das Steckverbinderset gemäß Fig. 4b und 4c im vollständig gesteckten Zustand in seiner Endposition;
Fig. 4e zeigt das Steckverbinderset gemäß Fig. 4d in teilweise weggebrochenem Zustand zur Verdeutlichung der vollständigen Steckung aller Steckkontakte;

### Ausführungsbeispiele der Erfindung

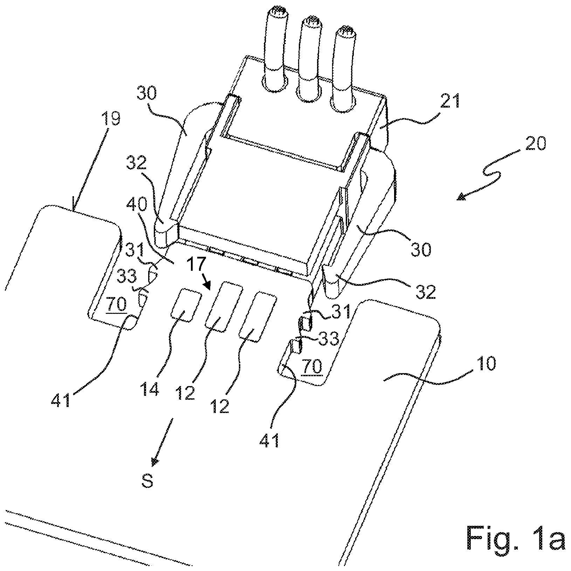

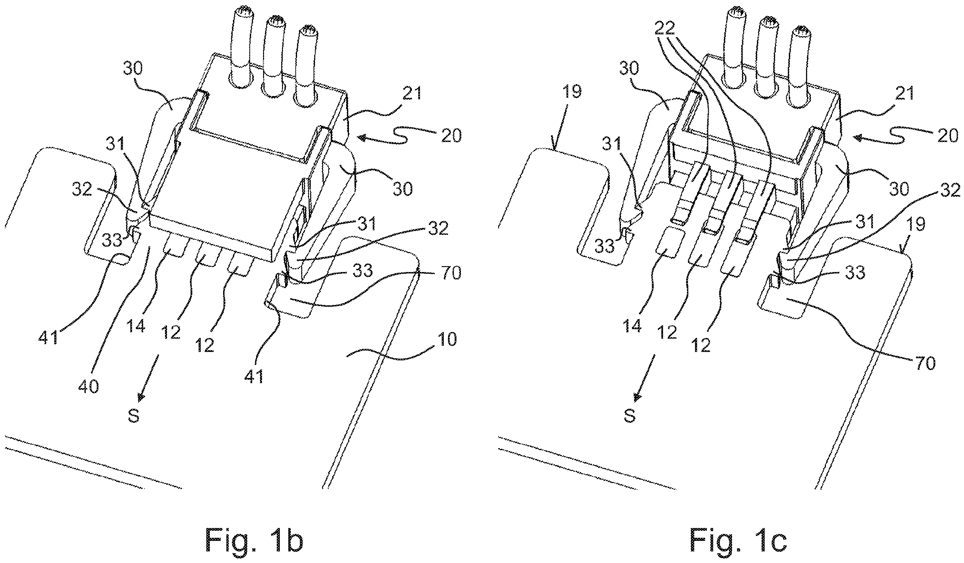

In den Figuren 1a bis 1e ist eine erste Variante ein Steckkontaktsets aus einem Leiterplattendirektsteckverbinder 20 und einer Leiterplatte 10 dargestellt. Die Leiterplatte 10 weist an einem Leiterplattenrand 19 eine Aussparung 70 auf, in der ein Vorsprung in Form einer Steckerzunge 40 angeordnet ist, auf der wiederum eine Steckkontaktleiste 17, bestehend aus einem Prüfkontaktelement 14 und Steckkontaktelementen 12 angeordnet ist. Das Prüfkontaktelement 14 und die Steckkontaktelemente 12 sind beispielsweise Leiterflächen auf der Oberfläche der Leiterplatte 10. Der Leiterplattendirektsteckverbinder 20 weist ein Gehäuse 21 auf, an dem Federarme 30 federnd nach innen, auf die Steckerzunge 40 zu angelenkt sind. Die Federarme 30 weisen an ihrem unteren Ende zweite Rastelemente 32 in Form von Rasthaken auf. Erste Rastelemente 31 sind an der Steckerzunge 40 an deren jeweils senkrecht zur Steckrichtung S begrenzenden Rändern 41 angeordnet. In Steckrichtung S beabstandet von den ersten Rastelementen 31 sind dritte Rastelemente 33 angeordnet. Sowohl die ersten Rastelemente 31 als auch die dritten Rastelemente 33 sind als Rasthaken ausgebildet, die mit den als zweite Rastelemente 32 ausgebildeten Rasthaken zusammenwirken. Hierbei erweist sich die federnde Anlenkung der Federarme 30 als besonders vorteilhaft. Der Leiterplattendirektsteckverbinder 20 wird in Steckrichtung S auf die Steckerzunge 40 geschoben solange bis die ersten Rastelemente 31 und die zweiten Rastelemente 32 verrastet sind. In diesem Zustand sind die Steckkontaktelemente 12 mit entsprechenden Kontaktelementen 22 des Leiterplattendirektsteckverbinders 20, die als Federkontaktelemente ausgebildet sind, elektrisch leitend verbunden. Nicht elektrisch leitend verbunden sind das entsprechende Steckkontaktelement 22 und der Prüfkontakt 14.

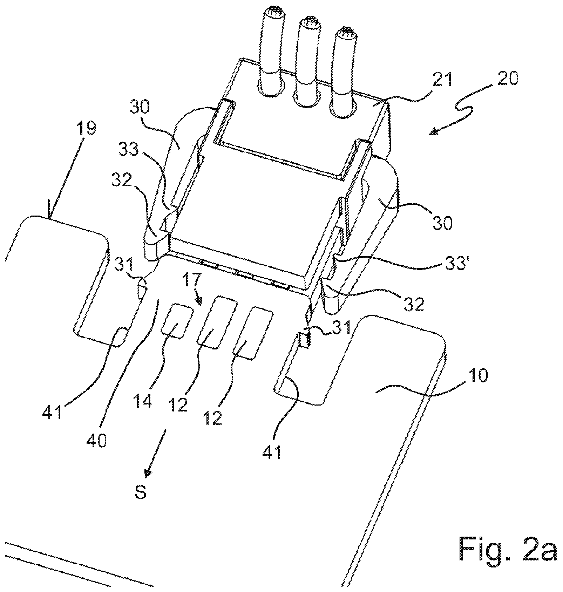

Auf die Funktion des Prüfkontaktes 14 wird nachfolgend noch eingegangen. Zunächst wird jedoch in Verbindung mit den Figuren 2a bis 2e ein alternatives Steckkontaktset aus Leiterplattendirektsteckverbinder 20 und Leiterplatte 10 beschrieben. Dabei sind gleiche Elemente mit den gleichen Bezugszeichen versehen, sodass zu deren Beschreibung auf das Vorstehende verwiesen wird. Im Unterschied zu den in Fig. 1a bis 1e dargestellten Lösungen ist hier jedoch das dritte Rastelement 33' nicht an den Rändern 41 der Steckerzunge 40 angeordnet, sondern als Teil der Federarme 30. Das dritte Rastelement 33' ist in diesem Falle entgegen der Steckrichtung S von dem zweiten Rastelement 32 beabstandet, während es bei der ersten erfindungsgemäßen Lösung in Steckrichtung S von dem Rastelement 31 beabstandet ist.

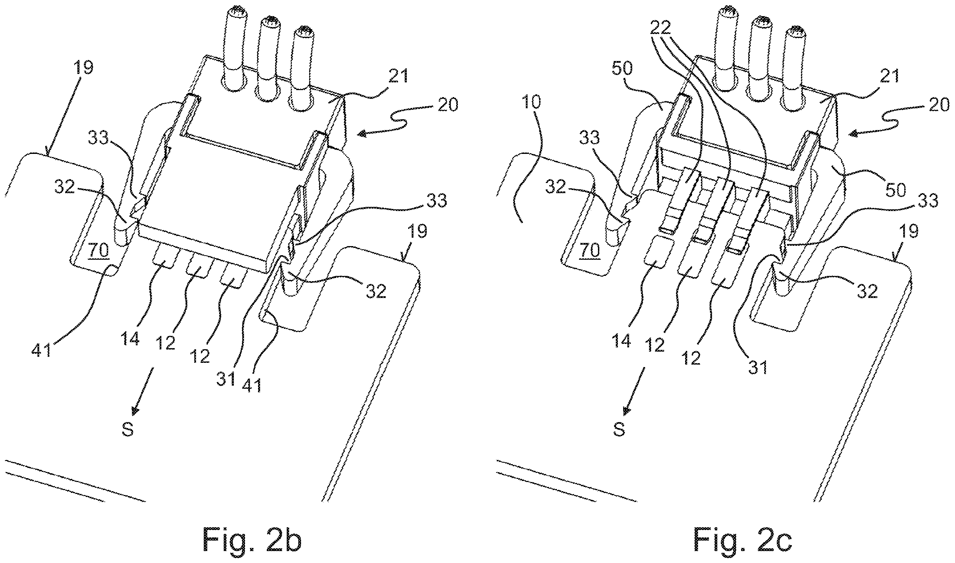

Fig. 2b und 2c zeigen wiederum eine Steckung, bei der Kontaktelemente 12 mit entsprechenden Kontaktelementen 22 des Leiterplattendirektsteckverbinders 20 elektrisch leitend verbunden sind, nicht jedoch der Prüfkontakt 14 mit dem entsprechenden Kontaktelement 22.

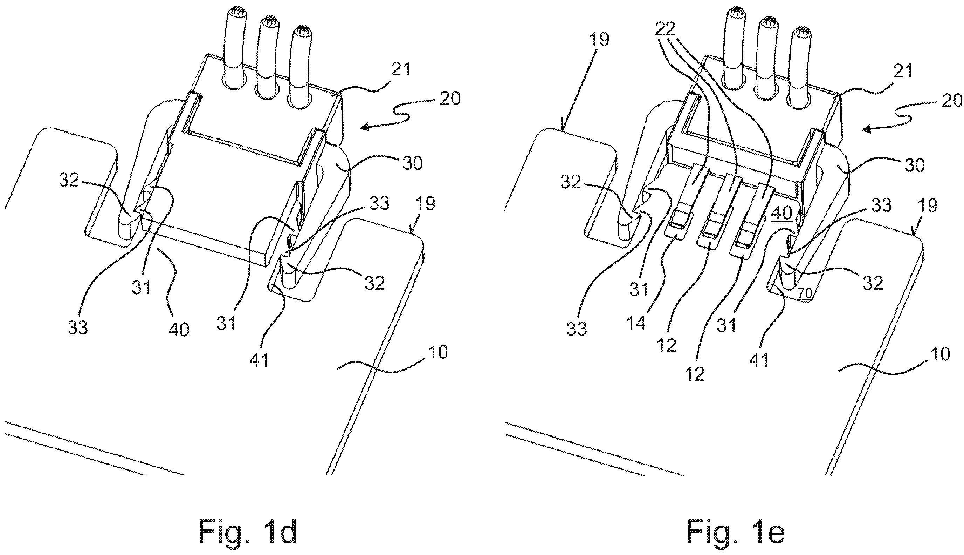

In Fig. 1d und 1e sind jeweils die Endpositionen dargestellt, in denen der Leiterplattendirektsteckverbinder 20 vollständig auf die entsprechende Kontaktleiste 17 der Leiterplatte 10 gesteckt ist. In diesem Falle sind die Rastelemente 32, die an den Federarmen 30 angeordnet sind mit den Rastelementen 33 an der Leiterplatte 10 verrastet. In diesem Zustand sind alle Kontaktelemente 12 sowie der Prüfkontakt 14 mit den entsprechenden Kontaktelementen 22 des Leiterplattendirektsteckverbinders 20 elektrisch leitend verbunden.

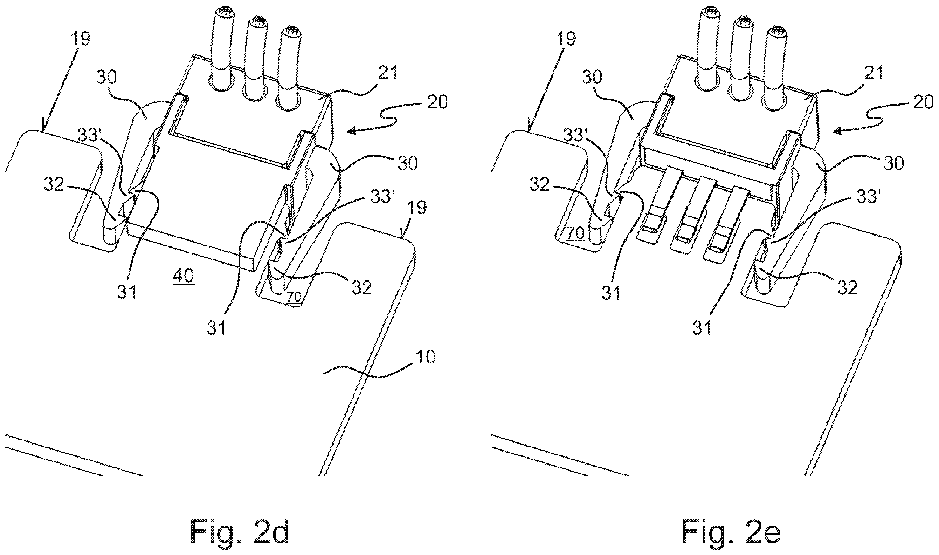

In den Fig. 2d und 2e ist die vollständige Steckung der zweiten erfindungsgemäßen Lösung dargestellt. In diesem Falle sind die dritten Rastelemente 33', die an den Federarmen 30 ausgebildet sind, mit den ersten Rastelementen 31, die an der Leiterplatte 10 ausgebildet sind, verrastet.

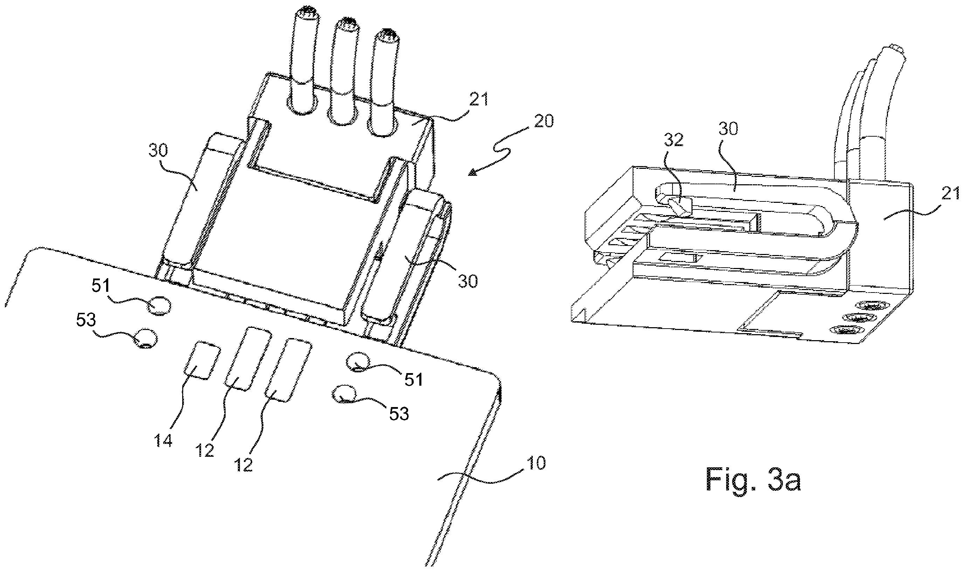

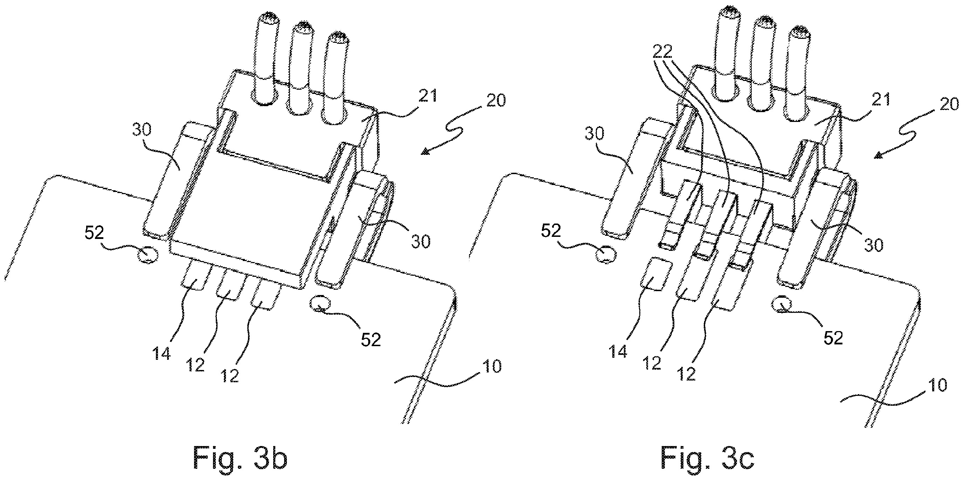

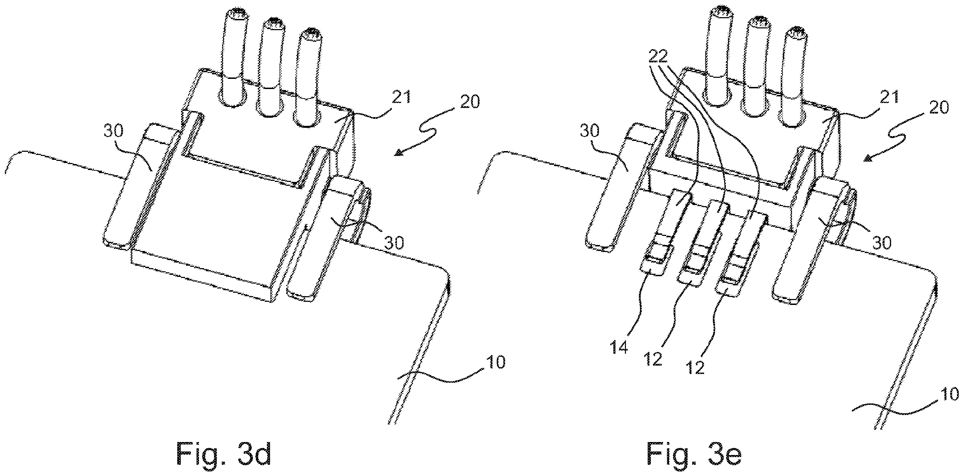

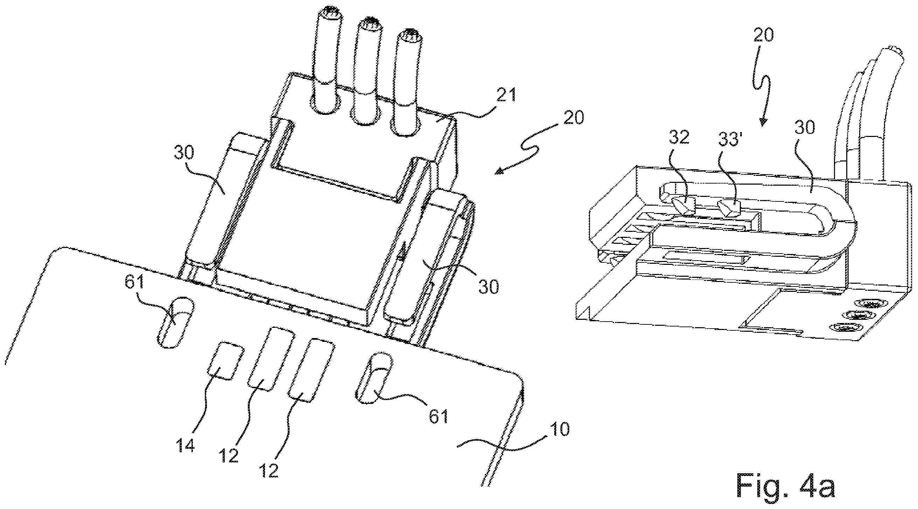

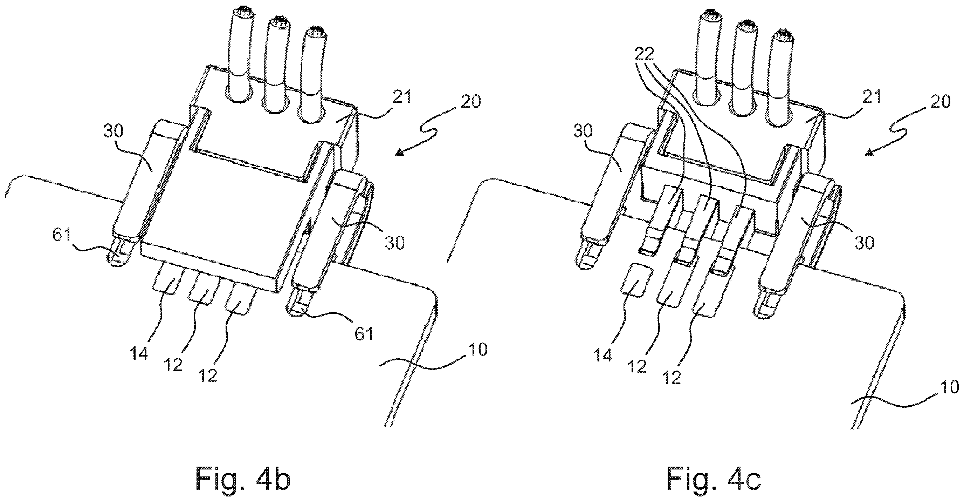

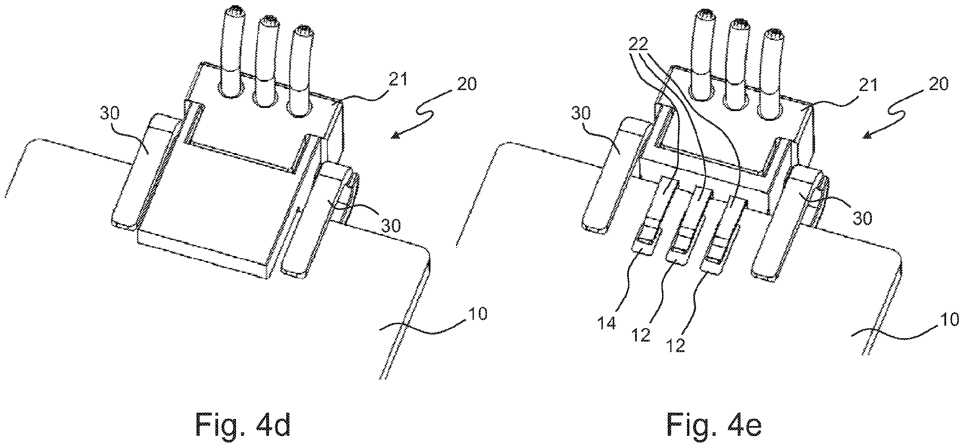

In den Fig. 3a bis 3e sowie 4a bis 4e sind eine dritte beziehungsweise eine vierte Ausführungsform des erfindungsgemäßen Steckkontakts dargestellt.

Gleiche Elemente sind mit den gleichen Bezugszeichen versehen wie in den Fig. 1a bis 1e bzw. 2a bis 2e, sodass zu deren Beschreibung auf das Vorstehende verwiesen wird.

Wie den Fig. 3a bis 3e und 4a bis 4e zu entnehmen ist, sind hier die Kontaktelemente 12 sowie der Prüfkontakt 14 nicht auf einer Steckerzunge angeordnet, sondern direkt am Leiterplattenrand selbst. Darüber hinaus sind die Rastelemente nicht als Rasthaken an dem die Steckerzunge begrenzenden Rand angeordnet, sondern als Öffnungen 51, 53 in der Leiterplatte ausgebildet. Dabei entsprechen den Öffnungen 51 die Rastelemente 31 und den Öffnungen 53 die dritten Rastelemente 33 in den Fig. 1a bis 1e. Auch bei der in Fig. 4a bis 4e beschriebenen weiteren Ausführungsform sind die Kontaktelemente 12 und der Prüfkontakt 14 ebenfalls nebeneinanderliegend am Platinenrand angeordnet und bilden die Steckkontaktleiste 17. Hier sind die ersten Kontaktelemente 61 als Langlöcher ausgebildet und die zweiten und dritten Rastelemente 32, 33 sind am Leiterplattensteckverbinder 20 an dort angeordneten Federarmen 30 ausgebildet. Die Steckvorgänge entsprechenden bei dem in Fig. 3a bis 3e dargestellten Ausführungsbeispiel denjenigen des in Fig. 1a bis 1e dargestellten Ausführungsbeispiels und die Steckvorgänge des in Fig. 4a bis 4e dargestellten Ausführungsbeispiels entsprechen im Wesentlichen denen des in Fig. 2a bis 2e dargestellten Ausführungsbeispiels, sodass auf das Vorstehende insoweit Bezug genommen wird.

Die Gehäuse 21 der Leiterplattendirektsteckverbinder 20 gemäß Fig. 1a bis 1e und 2a bis 2e unterscheiden sich geringfügig von denjenigen der Leiterplattendirektsteckverbinder gemäß Fig. 3a bis 3e und Fig. 4a bis 4e. Das sind jedoch lediglich konstruktive Ausgestaltungen. Das Prinzip der Funktionsweise ist identisch.

Wie aus den Figuren hervorgeht, ist dass als Prüfkontakt ausgebildete Kontaktelement 14, nachfolgend auch kurz als Prüfkontakt 14 bezeichnet, in Steckrichtung S kürzer ausgebildet als die Kontaktelemente 12. Es ist so kurz ausgebildet, dass bei einer Steckung, bei der nur die ersten und zweiten Rastelemente 31, 32 miteinander verrastet sind kein elektrischer Kontakt zwischen Prüfkontakt 14 und dem entsprechenden Kontaktelement 22 hergestellt wird. Erst wenn eine vollständige Steckung vorliegt, wenn also auch die dritten Rastelemente 33 beziehungsweise 33' verrastet sind, ist auch der Prüfkontakt 14 kontaktiert.

Um nun festzustellen, ob eine ordnungsgemäße Kontaktierung vorliegt, wird der Prüfkontakt 14 oder alternativ das mit dem Prüfkontakt 14 korrespondierende Kontaktelement 22 bestromt und festgestellt, ob ein Stromfluss zwischen dem Prüfkontakt 14 und korrespondierenden Kontaktelement 22 oder umgekehrt von dem Kontaktelement 22 zu dem Prüfkontakt 14 vorliegt. Wenn dies der Fall ist, wird von einer ordnungsgemäßen Steckung ausgegangen. Wenn dies nicht der Fall ist, liegt eine Kontaktunterbrechung vor zwischen Prüfkontakt 14 und korrespondierendem Kontaktelement 22. In diesem Falle muss von einer Halbsteckung oder nicht ordnungsgemäßen Steckung ausgegangen werden. Eine solche nicht ordnungsgemäße Steckung oder auch Halbsteckung kann als erster Rastpunkt bezeichnet werden. In einem zweiten Rastpunkt ist eine vollständige Steckung erreicht. In diesem Falle sind die ersten und zweiten Rastelemente 31, 32 bzw. 51, 32 oder 61, 32 miteinander verrastet. Nun ist ein Spiel vorgesehen, welches in Steckrichtung S eine gewisse Länge aufweist, die ein Bewegen des zweiten Rastelements 32 relativ zu dem ersten Rastelement 31 bzw. 51 oder 61 in und entgegen der Steckrichtung S ermöglicht. Dieses Spiel beträgt etwa 0,9 mm bis 1,0 mm. Es ist dem Funktionsablauf während des Steckvorgangs im Zusammenhang mit dem Prüfkontakt 14 geschuldet. Zunächst findet eine Verrastung der ersten und zweiten Rastelemente 31, 32 bzw. 51, 32 oder 61, 32 statt. Diese Verrastung muss, um den erwähnten Betrag, also zwischen 0,9 mm und 1,0 mm vor der Endlage (völlig gesteckter Zustand) erfolgen, um sicherzustellen, dass zwar alle Nutzkontakte, also alle Steckkontaktelemente 12 mit den entsprechenden Kontaktelementen 22 elektrisch leitend verbunden sind, nicht jedoch der kürzere Prüfkontakt 14, der in dieser Steckposition auf keinen Fall schon eine Berührung mit dem korrespondierenden Kontaktelement 22 in dem Steckverbinder 20 aufweisen darf. Dieser Zustand ist jeweils in den Figuren 1c und 2c bzw. 3c und 4c dargestellt. Während der Montage wird nun der Steckverbinder 20 vollständig auf die Leiterplatte 10 geschoben. Bei vollständigem Schieben des Leiterplattendirektsteckverbinders 20 auf die Leiterplatte 10 auf den Grund, also gewissermaßen bis zum Anschlag, sind alle Stecckontaktelemente 12 und auch der Prüfkontakt 14 mit den entsprechenden korrespondierenden Kontaktelementen 22 elektrisch leitend verbunden, also kontaktiert. Nun kann während der Montage der unerwünschte Fall auftreten, dass an dem Steckverbinder und/oder an den Kabeln, die zu ihm führen gezogen wird, sodass sich der Steckverbinder 20 etwas aus der Steckkontaktleiste 17 herauslöst, also etwas von der Leiterplatte 10 herauslöst. Das Herauslösen findet also nach einer anfänglich ordnungsgemäßen Steckung statt. Auch könnte der Fall eintreten, dass es während der Montage des Steckverbinders 20 an der Leiterplatte 10 zwar zu einer Verrastung des Rastelements 32 und des Rastelements 31 bzw. 51 oder 61 kommt, dass der Steckverbinder 20 aber nicht so tief gesteckt ist, dass der Prüfkontakt 14 und das entsprechende Kontaktelement 22 miteinander in elektrisch leitender Verbindung stehen. Diese Steckung wird während der Montage als Störung festgestellt und signalisiert. Hier handelt es sich zwar um einen Pseudofehler, der auch als solcher bezeichnet wird, denn die Kontaktelemente 22 der Leiterplatte 10 und des Steckverbinders 20 sind - bis auf den Prüfkontakt 14 - korrekt kontaktiert. Während der Montage wird allerdings eine Nichtkontaktierung des Prüfkontakts 14 als Fehler erkannt. In diesem Fall müsste ein Monteur den Steckverbinder 20 wieder ganz auf die Leiterplatte 10 durch Ausüben eines entsprechenden Drucks in Steckrichtung S drücken. Es versteht sich, dass insbesondere bei einer sehr großen Zahl von derartigen Steckkontaktsets, wie sie beispielsweise in Fahrzeugen verbaut werden, ein derartiges "Nachstecken" zeitaufwendig und für die Montage von Fahrzeugen am Fließband nicht erwünscht ist.

Um dies zu vermeiden, sieht die Erfindung ein drittes Rastelement 33, 33' in Form einer weiteren Rastnase vor. Im vollständig gesteckten Zustand, also dann, wenn der Steckverbinder 20 vollständig auf die Leiterplatte 10 gesteckt wurde und alle Kontaktelemente 12, 14, 22 miteinander elektrisch verbunden sind, rastet das dritte Rastelement 33 beziehungsweise 33' mit dem Rastelement 31, 51, 61, 32 ein und fixiert so möglichst spielfrei den Leiterplattendirektsteckverbinder 20 an der Leiterplatte 10.

Das dritte Rastelement 33 beziehungsweise 33' ermöglicht also eine Fixierung im Zustand der Vollsteckung, das heißt in einem dritten Rastpunkt, der sich von dem zweiten Rastpunkt, der in Fig. 1c, 2c bzw. 3c und 4c dargestellt ist, dadurch unterscheidet, dass während der Montage sichergestellt ist, dass die Steckkontaktsets vollständig gesteckt sind, was durch Feststellung eines gesteckten Prüfkontakts 14 erfasst werden kann. Dieser Zustand ist in Fig. 1d bzw. 3d und in Fig 2e bzw. 4e dargestellt. Dabei ist der Leiterplattendirektsteckverbinders an der Leiterplatte 10 fixiert und zwar so fixiert, dass auch eine Rüttelbelastung oder eine andere mechanische Belastung, beispielsweise eine Vibrationsbelastung oder dergleichen kein Herauslösen des Steckverbinders 20 aus der Leiterplatte 10 zulässt.

Eine ordnungsgemäße Steckung kann festgestellt werden, indem entweder der Prüfkontakt 14 oder sein korrespondierendes Kontaktelement 22 im Steckverbinder 20 bestromt wird. Dabei wird geprüft, ob ein Strom zwischen dem Prüfkontakt 14 und dem entsprechenden Kontaktelement 22 fließt. Ist dies nicht der Fall, so liegt keine ordnungsgemäße Steckung vor.

Dies ermöglicht eine automatisierte Prüfung von erfindungsgemäßen Steckkontaktsets auf das Vorliegen einer beispielsweise Halbsteckung oder nicht ordnungsgemäßen Steckung. Wird eine solche erkannt, so kann die Halbsteckung oder die nicht ordnungsgemäße Steckung noch im Montageprozess korrigiert werden.

## Patentansprüche

1. Steckkontaktset, umfassend eine Steckkontaktleiste (17) mit mehreren als Bestandteil einer Leiterplatte (10) ausgebildeten, im Bereich eines Leiterplattenrandes (19) angeordneten ersten Kontaktelementen (12,14), deren mindestens eines in Steckrichtung (S) als Prüfkontakt (14) mit geringerer Länge als die restlichen Kontaktelemente ausgebildet ist, und einen Steckverbinder (20) mit mehreren, in einem Gehäuse
(21) angeordneten zweiten Kontaktelementen (22), deren mindestens eines eingerichtet ist, mit dem Prüfkontakt (14) in elektrischen Kontakt zu treten, wobei an dem Leiterplattenrand (19) wenigstens ein erstes, als Teil der Leiterplatte (10) ausgebildetes Rastelement (31, 51) und an dem Gehäuse (21) wenigstens ein zweites Rastelement (32) angeordnet sind, die eingerichtet sind, aneinander zu verrasten, wenn die ersten Kontaktelemente (12, 14) mit den zweiten Kontaktelementen (22) vollständig kontaktiert sind, und wobei ein als Teil der Leiterplatte (10) ausgebildetes drittes, mit dem zweiten Rastelement (32) verrastbares Rastelement (33, 53) vorgesehen ist, das in Steckrichtung (S) von dem ersten Rastelement (31) so beabstandet angeordnet ist, dass durch eine Verrastung des dritten Rastelements (33, 53) mit dem zweiten Rastelement (32) eine möglichst spielfreie Fixierung des Gehäuses (21) an der Leiterplatte (10) im vollständig kontaktierten Zustand der ersten und zweiten Steckkontakte (12, 14, 22) erzielt wird, wobei die Steckkontaktleiste (17) genau einen Prüfkontakt (14) aufweist, der mittig in der Steckkontaktleiste (17) angeordnet ist.

2. Steckkontaktset, umfassend eine Steckkontaktleiste (17) mit mehreren als Bestandteil einer Leiterplatte (10) ausgebildeten, im Bereich eines Leiterplattenrandes (19) angeordneten ersten Kontaktelementen (12,14), deren mindestens eines in Steckrichtung (S) als Prüfkontakt (14) mit geringerer Länge als die restlichen Kontaktelemente ausgebildet ist, und einen Steckverbinder (20) mit mehreren, in einem Gehäuse (21) angeordneten zweiten Kontaktelementen (22), deren mindestens eines eingerichtet ist, mit dem Prüfkontakt (14) in elektrischen Kontakt zu treten, wobei an dem Leiterplattenrand (19) wenigstens ein erstes, als Teil der Leiterplatte (10) ausgebildetes Rastelement (31, 61) und an dem Gehäuse (21) wenigstens ein zweites Rastelement (32) angeordnet sind, die eingerichtet sind, aneinander zu verrasten, wenn die ersten Kontaktelemente (12, 14) mit den zweiten Kontaktelementen (22) vollständig kontaktiert sind, und wobei an ein an dem Gehäuse (21) angeordnetes drittes, mit dem ersten Rastelement (31, 61) verrastbares Rastelement (33') vorgesehen ist, das in Steckrichtung (S) von dem zweiten Rastelement (32) so beabstandet angeordnet ist, dass durch eine Verrastung des dritten Rastelements (33') mit dem ersten Rastelement (31, 61) eine möglichst spielfreie Fixierung des Gehäuses (21) an der Leiterplatte (10) im vollständig kontaktierten Zustand der ersten und zweiten Steckkontakte (12, 14, 22) erzielt wird, wobei die Steckkontaktleiste (17) genau einen Prüfkontakt (14) aufweist, der mittig in der Steckkontaktleiste (17) angeordnet ist.

3. Steckkontaktset nach Anspruch 1 oder 2, **dadurch gekennzeichnet, dass** die ersten Kontaktelemente (12, 14) auf der Leiterplatte (10) angeordnet sind.

4. Steckkontaktset nach Anspruch 1, **dadurch gekennzeichnet, dass** die ersten und dritten Rastelemente (31,33; 51,53, 61) in / an der Leiterplatte (10) als deren Teil ausgebildet sind.

5. Steckkontaktset nach Anspruch 4, **dadurch gekennzeichnet, dass** die ersten und dritten Rastelemente (31, 33) jeweils an Rändern (41), welche eine Steckerzunge (40), die als Teil der Leiterplatte (10) ausgebildet ist, quer zur Steckrichtung (S) begrenzen, angeordnet sind.

6. Steckkontaktset nach Anspruch 4, **dadurch gekennzeichnet, dass** die ersten und dritten Rastelemente (51, 53, 61) Öffnungen in der Leiterplatte (10) sind.

7. Steckkontaktset nach Anspruch 1 oder 2, **dadurch gekennzeichnet, dass** die zweiten Rastelemente (32) an an dem Gehäuse (20) angeordneten Federarmen (30) angeordnet sind.

8. Steckkontaktset nach Anspruch 2, **dadurch gekennzeichnet, dass** die zweiten und dritten Rastelemente (32, 33') an an dem Gehäuse (20) angeordneten Federarmen (70) angeordnet sind.

9. Steckkontaktset nach einem der vorstehenden Ansprüche, **dadurch gekennzeichnet, dass** die Rastelemente (31, 32, 33') Rasthaken sind.

10. Steckkontaktset nach Anspruch 1 oder 2, **dadurch gekennzeichnet, dass** alle restlichen ersten Steckkontakte (12) dieselbe Länge aufweisen.

11. Steckkontaktset nach Anspruch 1, **dadurch gekennzeichnet, dass** die zweiten Steckkontakte (22) in Steckrichtung (S) alle dieselbe Länge aufweisen.

12. Steckkontaktset nach einem der vorstehenden Ansprüche, **dadurch gekennzeichnet, dass** der Prüfkontakt (14) so kurz ausgebildet ist, dass er nicht in elektrischen Kontakt mit einem zweiten Steckkontakt (22) tritt, wenn das wenigstens eine erste Rastelement (31) nicht mit dem wenigstens einen zweiten Rastelement (32) verrastet ist.

13. Steckkontaktset nach einem der vorstehenden Ansprüche, **dadurch gekennzeichnet, dass** es einen ersten Rastpunkt, einen zweiten Rastpunkt und einen dritten Rastpunkt aufweist, wobei das wenigstens eine erste Rastelement (31) in allen drei Rastpunkten mit dem wenigstens einen zweiten Rastelement (32) verrastet ist und wobei in dem ersten Rastpunkt kein zweiter Steckkontakt (22) mit einem Prüfkontakt (14) elektrisch in Kontakt tritt, in dem zweiten Rastpunkt wenigstens ein zweiter Steckkontakt (22) mit einem Prüfkontakt (14) in elektrischen Kontakt tritt und in dem dritten Rastpunkt alle ersten und zweiten Steckkontakte (12, 14; 22) miteinander in Kontakt getreten sind und die beiden Gehäuseteile (11, 21) aneinander fixiert sind.

14. Steckkontaktset nach einem der vorstehenden Ansprüche, **dadurch gekennzeichnet, dass** die ersten Kontaktelemente (12, 14) Kontaktflächen auf der Leiterplatte (10) sind und dass die zweiten Kontaktelemente (22) Federkontaktelemente sind.

15. Verfahren zum Prüfen einer Verrastung des mindestens einen ersten Rastelements (31) mit dem mindestens einen zweiten und dritten Rastelements (32, 33) eines Steckkontaktsets nach einem der Ansprüche 1-13, umfassend
- Bestromen eines Prüfkontakts (14)
- Prüfen, ob ein Strom zwischen dem Prüfkontakt (14) und einem zweiten Steckkontakt (22) fließt, und
- Erkennen, dass eine Verrastung vorliegt, wenn ein Stromfluss detektiert wurde.

16. Verfahren zum Prüfen einer Verrastung des mindestens einen ersten Rastelements (31) mit dem mindestens einen zweiten und dritten Rastelements (32, 33) eines Steckkontaktsets nach einem der Ansprüche 1-13, umfassend
- Bestromen eines zweiten Steckkontakt (22), der eingerichtet ist, um elektrisch mit einem Prüfkontakt (14) in Kontakt zu treten,
- Prüfen, ob ein Strom zwischen dem Prüfkontakt (14) und diesem zweiten Steckkontakt (22) fließt, und
- Erkennen, dass eine Verrastung vorliegt, wenn ein Stromfluss detektiert wurde.

## Claims

1. Plug contact set, comprising a plug contact strip (17) having several first contact elements (12, 14) that are formed as components of a circuit board (10) and are arranged in the region of a circuit board edge (19), at least one of which contact elements (12, 14) being formed in the plugging direction (S) as a checking contact (14) having a smaller length than the remaining contact elements, and a plug connector (20) having several second contact elements (22) that are arranged in a housing (21), at least one of which contact elements (22) being set up to make electric contact with the checking contact (14), wherein at least one first latch element (31, 51) that is formed as part of the circuit board (10) is arranged on the circuit board edge (19) and at least one second latch element (32) is arranged on the housing (21), said latch elements being set up to latch with one another when the first contact elements (12, 14) are completely contacted by the second contact elements (22), and wherein a third latch element (33, 53) that is formed as part of the circuit board (10) and that is able to latch with the second latch element (32) is provided that is arranged to be spaced apart from the first latch element (31) in the plugging direction (S) in such a way that, by latching the third latch element (33, 53) to the second latch element (32), an as clearance-free as possible fixing of the housing on the circuit board (10) in the completely contacted state of the first and second plug contacts (12, 14, 22) is achieved, wherein the plug contact strip (17) has precisely one checking contact (14), which is arranged centrally in the plug contact strip (17).

2. Plug contact set, comprising a plug contact strip (17) having several first contact elements (12, 14) that are formed as components of a circuit board (10) and are arranged in the region of a circuit board edge (19), at least one of which contact elements (12, 14) being formed in the plugging direction (S) as a checking contact (14) having a smaller length than the remaining contact elements, and a plug connector (20) having several second contact elements (22) that are arranged in a housing (21), at least one of which contact elements (22) being set up to make electric contact with the checking contact (14), wherein at least one first latch element (31, 51) that is formed as part of the circuit board (10) is arranged on the circuit board edge (19) and at least one second latch element (32) is arranged on the housing (21), said latch elements being set up to latch with one another when the first contact elements (12, 14) are completely contacted by the second contact elements (22), and wherein a third latch element (33') that is arranged on the housing (21) and that is able to latch with the first latch element (31, 61), said third latch element (33') being arranged to be spaced apart from the second latch element (32) in the plugging direction (S) in such a way that, by latching the third latch element (33') to the first latch element (31, 61), a fixing of the housing (21) that is as clearance-free as possible on the circuit board (10) in the completely contacted state of the first and second plug contacts (12, 14, 22) is achieved, wherein the plug contact strip (17) has precisely one checking contact (14), which is arranged centrally in the plug contact strip (17).

3. Plug contact set according to claim 1 or 2, **characterised in that** the first contact elements (12, 14) are arranged on the circuit board (10).

4. Plug contact set according to claim 1, **characterised in that** the first and third latch elements (31, 33; 51, 53, 61) are formed in / on the circuit board (10) as a part thereof.

5. Plug contact set according to claim 4, **characterised in that** the first and third latch elements (31, 33) are in each case arranged on edges (41) which border, transversely to the plugging direction (S), a plugging tongue (40) that is formed as part of the circuit board (10).

6. Plug contact set according to claim 4, **characterised in that** the first and third latch elements (51, 53, 61) are openings in the circuit board (10).

7. Plug contact set according to claim 1 or 2, **characterised in that** the second latch elements (32) are arranged on the spring arms (30) arranged on the housing (20).

8. Plug contact set according to claim 2, **characterised in that** the second and third latch elements (32, 33') are arranged on the spring arms (70) arranged on the housing (20).

9. Plug contact set according to one of the preceding claims, **characterised in that** the latch elements (31, 32, 33') are latch hooks.

10. Plug contact set according to claim 1 or 2, **characterised in that** all remaining first plug contacts (12) have the same length.

11. Plug contact set according to claim 1, **characterised in that** the second plug contacts (22) all have the same length in the plugging direction (S).

12. Plug contact set according to one of the preceding claims, **characterised in that** the checking contact (14) is formed to be so short that it does not come into electric contact with a second plug contact (22) when the at least one first latch element (31) is not latched to the at least one second latch element (32).

13. Plug contact set according to one of the preceding claims, **characterised in that** it has a first latch point, a second latch point and a third latch point, wherein the at least one first latch element (31) is latched in all three latch points to the at least one second latch element (32) and wherein, in the first latch point, there is not a second plug contact (22) in electrical contact with a checking contact (14) in which second latch point at least one second plug contact (22) comes into electrical contact with a checking contact (14) and, in the third latch point, all first and second plug contacts (12, 14; 22) have come into contact with one another and the two housing parts (11, 21) are fixed to one another.

14. Plug contact set according to one of the preceding claims, **characterised in that** the first contact elements (12, 24) are contact surfaces on the circuit board (10) and the second contact elements (22) are spring contact elements.

15. Method for checking a latching of the at least one first latch element (31) to the at least one second and third latch element (32, 33) of a plug contact set according to one of claims 1 to 13, comprising
- energising a checking contact (14)
- checking whether a current is flowing between the checking contact (14) and a second plug contact (22), and
- determining that a latching is present when a current flow has been detected.

16. Method for checking a latching of the at least one first latch element (31) to the at least one second and third latch element (32, 33) of a plug contact set according to one of claims 1 to 11, comprising
- energising a second plug contact (22) which is configured to come into electrical contact with a checking contact (14),
- checking whether a current is flowing between the checking contact (14) and this second plug contact (22), and
- determining that a latching is present when a current flow has been detected.

## Revendications

1. Ensemble de contacts enfichables, comprenant : une barrette de contact enfichable (17) avec plusieurs premiers éléments de contact (12, 14) formés comme partie d'une carte de circuit imprimé (10) et disposés à proximité d'un bord (19) de ladite carte de circuit imprimé, dont au moins un sert de contact de contrôle (14) conçu avec une longueur, dans le sens de l'enfichage (S), qui est inférieure à celle des autres éléments de contact ; et un connecteur enfichable (20) présentant plusieurs deuxièmes éléments de contact (22) agencés dans un boîtier (21), dont au moins un est conçu pour venir en contact électrique avec le contact de contrôle (14), dans lequel ensemble il est disposé, sur le bord (19) de la carte de circuit imprimé, au moins un premier élément d'encliquetage (31, 51) faisant partie de la carte de circuit imprimé (10) et, sur le boîtier (21), au moins un deuxième élément d'encliquetage (32), lesquels éléments d'encliquetage sont formés pour un encliquetage mutuel lorsque les premiers éléments de contact (12, 14) sont mis totalement en contact avec les deuxièmes éléments de contact (22), et dans lequel ensemble il est prévu un troisième élément d'encliquetage (33, 53) faisant partie de la carte de circuit imprimé (10) et susceptible de s'encliqueter avec le deuxième élément d'encliquetage (32), lequel est écarté, dans le sens de l'enfichage (S), du premier élément d'encliquetage (31) de telle façon que, à la suite d'un encliquetage du troisième élément d'encliquetage (33, 53) avec le deuxième élément d'encliquetage (32), il se produise une fixation aussi exempte de jeu que possible du boîtier (21) sur la carte de circuit imprimé (10) à l'état de contact total des premier et deuxième contacts enfichables (12, 14, 22), ladite barrette de contact enfichable (17) présentant précisément un contact de contrôle (14) disposé au centre de la barrette de contact enfichable (17).

2. Ensemble de contacts enfichables, comprenant : une barrette de contact enfichable (17) présentant plusieurs premiers éléments de contact (12, 14) formés comme partie d'une carte de circuit imprimé (10) et disposés à proximité d'un bord (19) de ladite carte de circuit imprimé, dont au moins un sert de contact de contrôle (14) conçu avec une longueur, dans le sens de l'enfichage (S), qui est inférieure à celle des autres éléments de contact ; et un connecteur enfichable (20) présentant plusieurs deuxièmes éléments de contact (22) agencés dans un boîtier (21), dont au moins un est conçu pour venir en contact électrique avec le contact de contrôle (14), dans lequel ensemble il est disposé, sur le bord (19) de la carte de circuit imprimé, au moins un premier élément d'encliquetage (31, 61) faisant partie de la carte de circuit imprimé (10) et, sur le boîtier (21), au moins un deuxième élément d'encliquetage (32), lesquels éléments d'encliquetage sont formés pour un encliquetage mutuel lorsque les premiers éléments de contact (12, 14) sont mis totalement en contact avec les deuxièmes éléments de contact (22), et dans lequel ensemble il est prévu, sur le boîtier (21), un troisième élément d'encliquetage (33') susceptible de s'encliqueter avec le premier élément d'encliquetage (31, 61) et qui est écarté, dans le sens de l'enfichage (S), du deuxième élément d'encliquetage (32) de telle façon que, à la suite d'un encliquetage du troisième élément d'encliquetage (33') avec le premier élément d'encliquetage (31, 61), il se produise une fixation aussi exempte de jeu que possible du boîtier (21) sur la carte de circuit imprimé (10) à l'état de contact total des premier et deuxième contacts enfichables (12, 14, 22), ladite barrette de contact enfichable (17) présentant précisément un contact de contrôle (14) disposé au centre de la barrette de contact enfichable (17).

3. Ensemble de contacts enfichables selon la revendication 1 ou 2, **caractérisé en ce que** les premiers éléments de contact (12, 14) sont disposés sur la carte de circuit imprimé (10).

4. Ensemble de contacts enfichables selon la revendication 1, **caractérisé en ce que** les premiers et troisièmes éléments d'encliquetage (31, 33 ; 51, 53, 61) font partie de la carte de circuit imprimé (10) en étant présents dessus ou dedans.

5. Ensemble de contacts enfichables selon la revendication 4, **caractérisé en ce que** les premiers et troisièmes éléments d'encliquetage (31, 33) sont disposés respectivement sur des bords (41) délimitant, transversalement au sens de l'enfichage (S), une languette enfichable (40) faisant partie de la carte de circuit imprimé (10).

6. Ensemble de contacts enfichables selon la revendication 4, **caractérisé en ce que** les premiers et troisièmes éléments d'encliquetage (51, 53, 61) consistent en des ouvertures pratiquées dans la carte de circuit imprimé (10).

7. Ensemble de contacts enfichables selon la revendication 1 ou 2, **caractérisé en ce que** les deuxièmes éléments d'encliquetage (32) sont disposés sur des bras à ressort (30) disposés sur le boîtier (20).

8. Ensemble de contacts enfichables selon la revendication 2, **caractérisé en ce que** les deuxièmes et troisièmes éléments d'encliquetage (32, 33') sont disposés sur des bras à ressort (70) disposés sur le boîtier (20).

9. Ensemble de contacts enfichables selon l'une des revendications précédentes, **caractérisé en ce que** les éléments d'encliquetage (31, 32, 33') consistent en des crochets d'encliquetage.

10. Ensemble de contacts enfichables selon la revendication 1 ou 2, **caractérisé en ce que** tous les premiers contacts enfichables (12) restants présentent la même longueur.

11. Ensemble de contacts enfichables selon la revendication 1, **caractérisé en ce que** les deuxièmes contacts enfichables (22) présentent tous la même longueur dans le sens de l'enfichage (S).

12. Ensemble de contacts enfichables selon l'une des revendications précédentes, **caractérisé en ce que** le contact de contrôle (14) est suffisamment court pour ne pas venir en contact électrique avec un deuxième contact enfichable (22) lorsque l'au moins un premier élément d'encliquetage (31) n'est pas encliqueté avec l'au moins un deuxième élément d'encliquetage (32).

13. Ensemble de contacts enfichables selon l'une des revendications précédentes, **caractérisé en ce qu'**il présente un premier point d'encliquetage, un deuxième point d'encliquetage et un troisième point d'encliquetage, ledit au moins un premier élément d'encliquetage (31) étant encliqueté avec l'au moins un deuxième élément d'encliquetage (32) au niveau desdits trois points d'encliquetage et au niveau du premier point d'encliquetage aucun deuxième contact enfichable (22) ne venant en contact électrique avec un contact de contrôle (14), au niveau du deuxième point d'encliquetage au moins un deuxième contact enfichable (22) venant en contact électrique avec le contact de contrôle (14) et au niveau du troisième point d'encliquetage tous les premiers et deuxièmes contacts enfichables (12, 14 ; 22) étant venus en contact mutuel et les deux parties de boîtier (11, 21) étant fixées l'une à l'autre.

14. Ensemble de contacts enfichables selon l'une des revendications précédentes, **caractérisé en ce que** les premiers éléments de contact (12, 14) sont des surfaces de contact présentes sur la carte de circuit imprimé (10) et **en ce que** les deuxièmes éléments de contact (22) sont des éléments de contact à ressort.

15. Procédé de contrôle de l'encliquetage de l'au moins un premier élément d'encliquetage (31) avec les au moins un deuxième et troisième éléments d'encliquetage (32, 33) d'un ensemble de contacts enfichables selon l'une des revendications 1 à 13, comprenant
- la mise sous tension d'un contact de contrôle (14),
- le contrôle du passage du courant entre le contact de contrôle (14) et un deuxième contact enfichable (22), et
- l'identification du fait qu'un encliquetage est réalisé si le passage du courant est détecté.

16. Procédé de contrôle de l'encliquetage de l'au moins un premier élément d'encliquetage (31) avec les au moins un deuxième et troisième éléments d'encliquetage (32, 33) d'un ensemble de contacts enfichables selon l'une des revendications 1 à 13, comprenant
- la mise sous tension d'un deuxième contact enfichable (22) conçu pour venir en contact électrique avec un contact de contrôle (14),
- le contrôle du passage du courant entre le contact de contrôle (14) et ce deuxième contact enfichable (22), et
- l'identification du fait qu'un encliquetage est réalisé si le passage du courant est détecté.
